(19) Europäisches Patentamt / European Patent Office / Office européen des brevets

(11) **EP 1 115 121 B1**

(12) **EUROPEAN PATENT SPECIFICATION**

(45) Date of publication and mention of the grant of the patent:
**05.10.2011 Bulletin 2011/40**

(51) Int Cl.:
*G21K 5/10* (2006.01)    *B65B 55/16* (2006.01)

(21) Application number: **01200709.2**

(22) Date of filing: **16.03.1994**

(54) **Irradiation system utilizing conveyor-transported article carriers**

Bestrahlungssystem mit Fördereinrichtung für Artikelträgerelemente

Système d'irradiation utilisant des supports d'articles transportés par convoyeur

(84) Designated Contracting States:
**AT BE CH DE DK ES FR GB GR IE IT LI LU MC NL PT SE**

(30) Priority: **19.03.1993 US 33392**

(43) Date of publication of application:
**11.07.2001 Bulletin 2001/28**

(62) Document number(s) of the earlier application(s) in accordance with Art. 76 EPC:
**00100048.8 / 0 999 556**
**94911651.1 / 0 746 870**

(73) Proprietor: **THE TITAN CORPORATION**
**San Diego, California 92121-1002 (US)**

(72) Inventors:
• **Peck, Richard O.**
  **Lakewood,**
  **Colorado 80215 (US)**
• **Pageau, Gary Michael**
  **Englewood,**
  **Colorado 80112 (US)**
• **Williams, Colin Brian**
  **La Jolla, CA 92037 (US)**
• **Allen, John Thomas**
  **San Diego,**
  **California 92130 (US)**

(74) Representative: **Dempster, Benjamin John Naftel et al**
**Withers & Rogers LLP**
**Goldings House**
**2 Hays Lane**
**London**
**SE1 2HW (GB)**

(56) References cited:
US-A- 3 564 241    US-A- 3 676 675
US-A- 4 020 354    US-A- 4 852 138
US-A- 5 096 553

## EP 1 115 121 B1

**Description**

## BACKGROUND OF THE INVENTION

The present invention generally pertains to irradiation systems that utilize a conveyor for transporting articles past a radiation source and is particularly directed to conveyor systems that transport article carriers past a given location and to the article carriers used therewith.

Irradiation systems are used for irradiating articles, such as foodstuffs, food utensils, medical devices, consumer goods, cosmetics, and waste products and their containers, with high energy electromagnetic radiation, such as an electron beam, X-rays and microwaves, for the purpose of sterilizing such articles.

US-A-3 564 241 describes irradiation system apparatus, including a process conveyor for transporting article carriers past a radiation source at a first speed; a transport conveyor for transporting the article carriers from a loading area at a second speed that differs from said first speed; and a load conveyor for transporting the article carriers from the transport conveyor to position the article carriers on the process conveyor in such a manner that when the article carriers are positioned on the process conveyor there is a predetermined separation distance between adjacent positioned article carriers. After a first side of the articles carried by a given article carrier has been irradiated, the article carrier is reoriented for retransportation past the radiation course by the process conveyor so that a second side of the carried articles is irradiated.

US-A-4 852 138 describes irradiation system apparatus including a plurality of conveyor lines for transporting article carriers past radiation sources in such a manner that both sides of articles carried by the article carriers are irradiated.

US 4020354 disclose an apparatus for treating tyre making components by controlled exposure to high voltage electron beam radiation. The apparatus includes a plurality of sources of radiation, a walled chamber housing the sources, an entry and an exit each having a labyrinthine passage between said chamber and the surrounding space, conveyor means comprising a plurality of conveyors each having a conveying surface. The apparatus further includes a plurality of identical and independent motor drives each drivingly connected respectively to only one of said conveyors and operable to drive its respectively associated conveyor at a speed different from and independent of the speed of another of said conveyors, whereby each conveyor can travel through an enclosure at a speed proportional to the radiation dosage appropriate to a particular tyre component carried thereon.

## SUMMARY OF INVENTION

According to a first aspect of the present invention, there is provided a system for irradiating articles according to claim 1.

According to a second aspect of the present invention, there is provided a method of irradiating articles according to claim 7.

Additional features of the present invention are specified in the dependent claims.

## BRIEF DESCRIPTION OF THE DRAWING

Figure 1 illustrates a preferred embodiment of the irradiation systems of the present invention, with the ceiling and the supper portion of the walls of the housing not being shown in order to better illustrate the irradiation system contained therein.
Figure 2 illustrates a portion of the system illustrated in Figure 1, as viewed from a different perspective.
Figure 3A is a side plan view of an article carrier included in the system illustrated in Figures 1 and 2.
Figure 3B is an end plan view of the article carrier of Figure 3A supported from an overhead track.
Figure 3C is a top plan view of the article carrier of Figures 3A and 3B.
Figure 4 is a top plan view of a number of article carriers being supported by a portion of the transport conveyor prior to transport by the load conveyor and of a number of article carriers being transported by the process conveyor after having been transported by the load conveyor.

## DETAILED DESCRIPTION

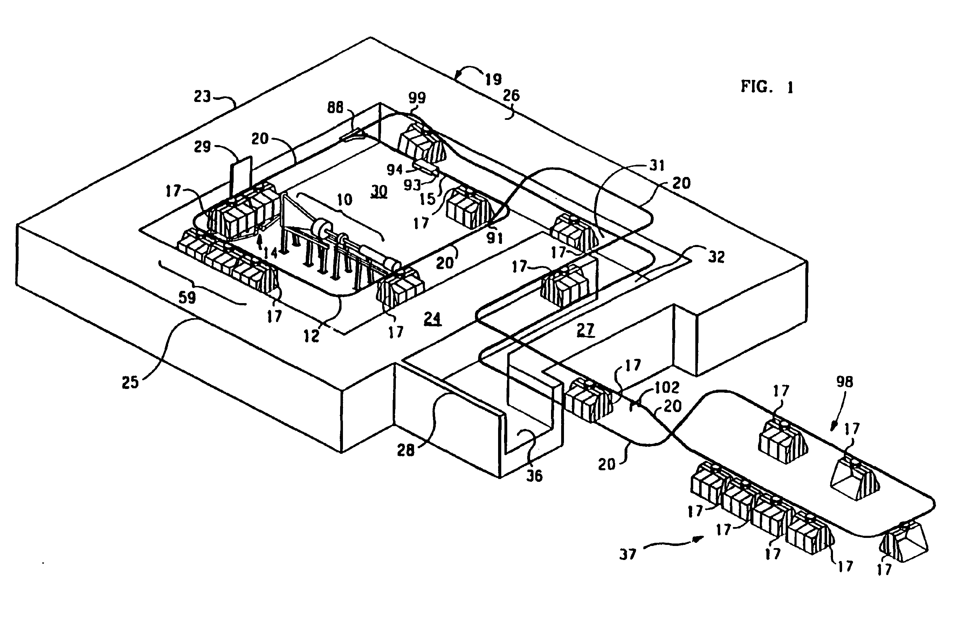

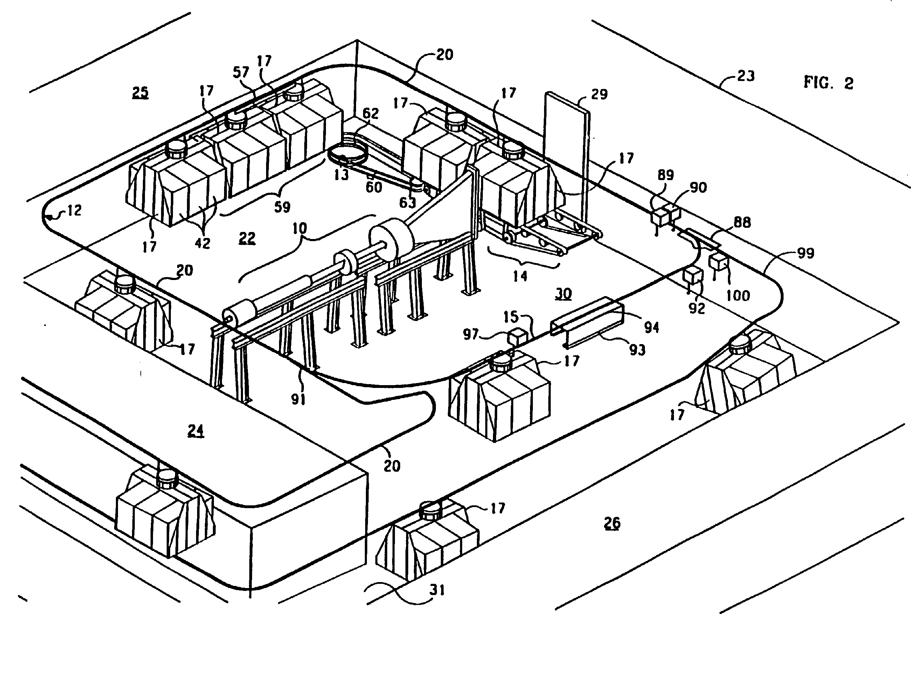

Referring to Figures 1 and 2. a preferred embodiment of the radiation system of the present invention includes a radiation source 10. a conveyor system that includes an overhead transport conveyor 12, a load conveyor 13, a process conveyor 14 and a reroute conveyor 15, a plurality of article carriers 17. a system control circuit 18 and a housing 19.

2

The system controller 18 is located outside the housing 19.

The radiation source 10 is a 10-million-electron-volt linear accelerator that provides an electron beam for irradiating articles transported past the radiation source 10 by the process conveyor 14. The radiation source 10 is disposed along an approximately horizontal axis and scans articles in the article carriers 10 being transported by the process conveyor 14 with a radiation beam that scans the transported articles at a given rate in a plane perpendicular to the direction of transport.

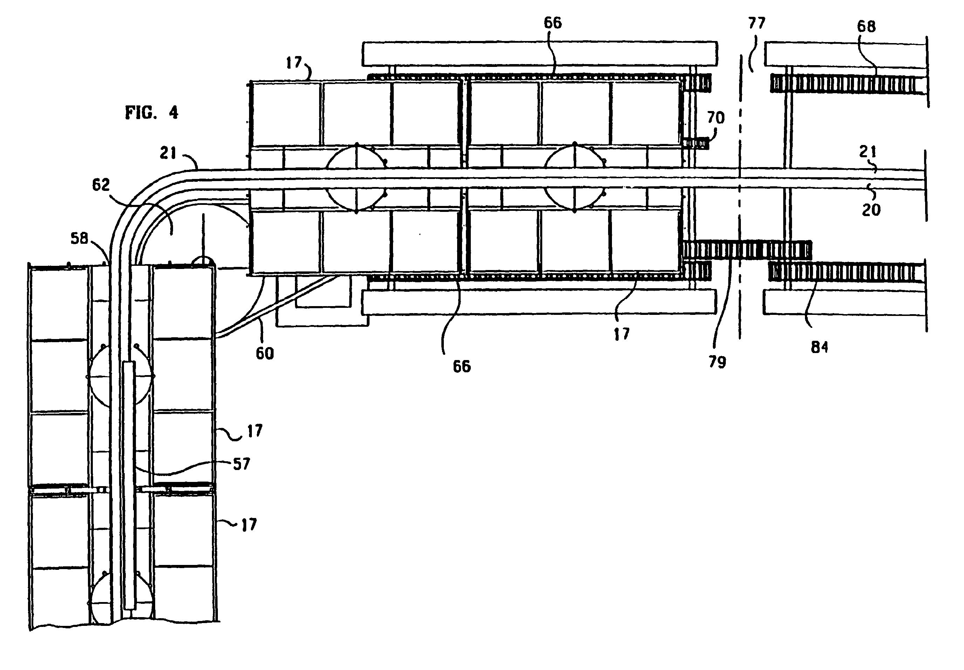

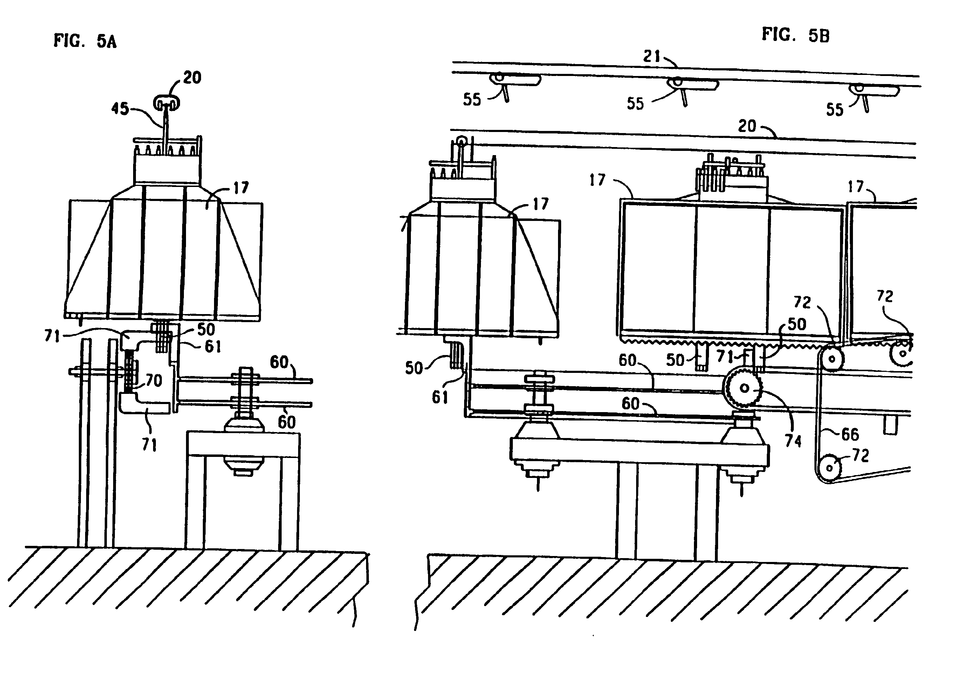

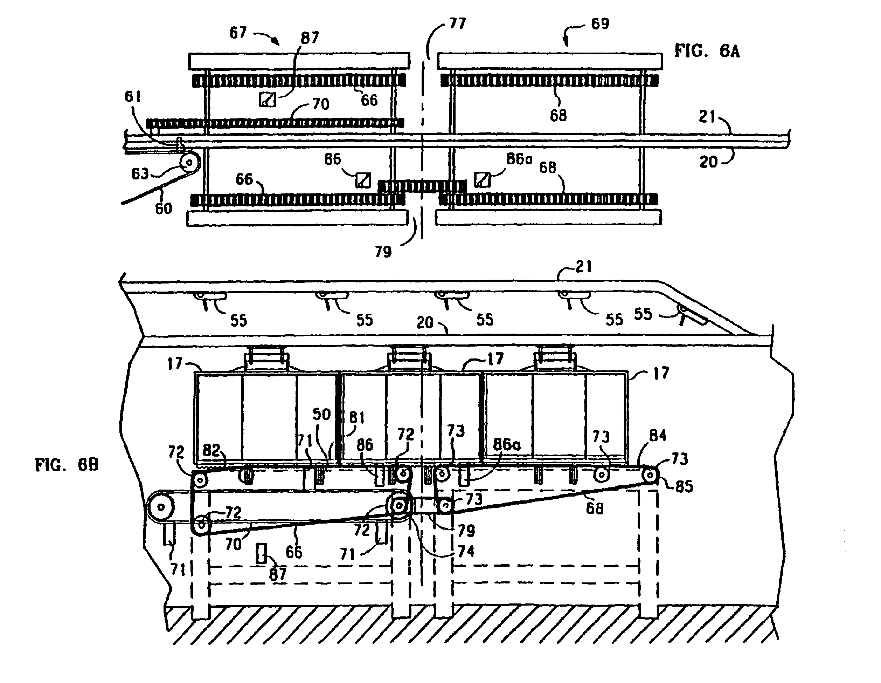

The transport conveyor 12 is an overhead power-and-free conveyor that includes a track 20 and a slotted tube 21 (Figures 4, 5B, 6B and 9) containing a continuously driven chain 54 with dogs 55 attached thereto disposed adjacent the track 20 except in the loading area 34 and the unloading area 98. where the track is disposed along a different path from the tube 21, and except where the track 20 passes over the load conveyor 13 and the process conveyor 14, where the tube 21 is elevated in relation to the track 20. The track 20 also is a slotted tube.

The use of a power-and-free conveyor as the transport conveyor 12 enables different article carriers 17 to be transported throughout the conveyor system at different required speeds in accordance with where in the conveyor system the article carriers 17 are being transported, because such transport in different parts of the system can either be powered by and thus at the speed of the transport conveyor 12, or free of the power of the transport conveyor and thus at a speed independent of the speed of the transport conveyor 12 while maintaining contact with the track 20 of the transport conveyor 12 so that the transport of each article carriers 17 by the transport conveyor 12 can be resumed after an interval during which the article carrier 17 is not being transported by the transport conveyor 12.

The housing 19 includes a floor 22, a ceiling (not shown) and set of walls 23, 24, 25, 26. 27, 28, all of which are made of radiation shielding material, such as reinforced concrete. A beam stop 29 is disposed on the opposite side of the process conveyor 14 from the radiation source 10. The housing 19 defines a process chamber 30 in which the radiation source 10 and a portion of the transport conveyor 12 are disposed, an entry 31 Into the chamber 30 for the transport conveyor 12 and a passageway 32 for the transport conveyor 12 leading to the entry 31 into the chamber 30. Another portion of the transport conveyor 12 is located at a loading area 34 outside the set of walls 23. 24. 25. 26. 27, 28 and shielded by the set of walls 23. 24, 25, 26. 27. 28 from radiation emitted by the radiation source 10.

A first wall 23 is disposed in front of the radiation source 10 for absorbing radiation received directly from the radiation source 10. The first wall 23 is approximately 3m (ten feet) thick.

A second wall 24 is disposed behind the radiation source 10 and opposite the first wall 23 for absorbing radiation from the radiation source 10 that is reflected within the process chamber 30. The second wall 24 is approximmately 2,13 m (seven feet) thick.

A third wall 25 is disposed on one side of the radiation source 10 and connects the first wall 23 and the second wall 24 for absorbing the reflected radiation. The third wall 25 is approximately 2,13 m (seven feet) thick.

A fourth wall 26 is disposed on the other side of the radiation source 10 for absorbing the reflected radiation. The fourth wall 26 is connected to the first wall 23 and is separated from the second wall 24 to define the entry 31 into the process chamber 30 for the transport conveyor 12. A fourth wall 26 is approximately 2,13 m (seven feet) thick.

A fifth wall 27 is connected to the fourth wall 26 and disposed in relation to the second wall 24 for defining the passageway 32 for the transport conveyor 12 between the second wall 24 and the fifth wall 27 and for absorbing said reflected radiation that is further reflected through the entry 31 from the process chamber 30. The fifth wall is approximately seven feet thick adjacent the entry 31 and approximately three feet thick adjacent the passageway 32.

A sixth wall 28 is connected to the second wall 24 and disposed in relation to the fifth wall 27 for defining an opening 36 into the passageway 32 for the transport conveyor 12 between the fifth wall 27 and the sixth wall 28 and for absorbing said reflected radiation that is further reflected through the passageway 32 from the process chamber 30. The sixth wall 28 is approximately 30 cm (one foot) think.

To minimize the size of the process chamber 30, and thus the amount of shielding material required, the transport conveyor track 20 has several 90-degree turns, including one shortly prior to where the article carriers 17 are positioned on the process conveyor 14.

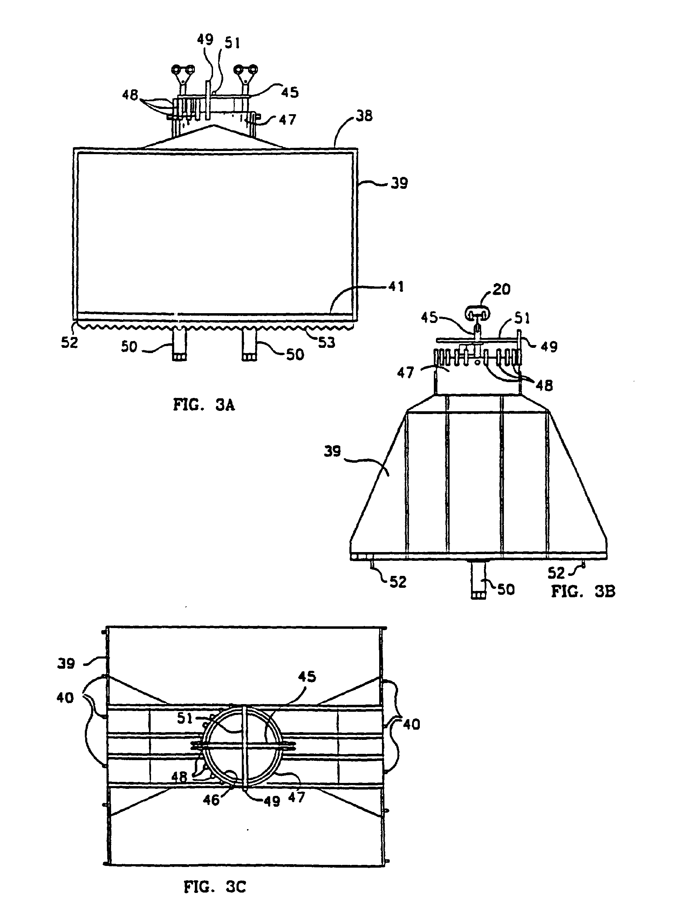

Referring to Figures 3A, 3B and 3C an individual article carrier 17 includes a top cross member 38. end members 39 as defined by the direction in which the article carrier 17 is transported by the process conveyor 14, with the end members 39 having supporting struts 40 on the outside surfaces of the end members 39, and a platform 41 for receiving the articles to be sterilized or cartons 42 containing such articles, as shown in Figures 1 and 2.

Individual article cartons 42 may be so dimensioned that the crossbeam exposure space within the article carrier 17 is efficiently utilized. When the articles to be sterilized are elongated, the cartons 42 are dimensioned to contain the elongated articles in such an orientation that when the article carrier 17 is transported past the radiation source 10, the elongated articles are irradiated approximately normal to the long dimension of the elongated articles to thereby achieve optimum article sterility together with optimum article throughput efficiency with respect to utilization of the energy of the radiation beam emitted by the radiation source 10 as the articles are transported past the radiation source 10.

An individual article carrier 17 further includes a trolley 45. an inner collar 46 that is non-rotatably attached to the trolley 45, an outer collar 47 that is attached to the top cross member 38 and rotatably coupled to the inner collar 46, a series of pins 48 attached to the outer collar 47, a striker tab 49 extending vertically from one side of the outer collar 47, a pair of lugs 50 extending downwardly from the platform 41 along the longitudinal axis of the article carrier 17, a bar 51 attached to the trolley 45 and a pair of members 52 attached to the bottom of the platform 41 on opposite lateral sides of the platform 41, wherein each member 52 has a a serrated edge 53 extending downwardly from the platform 41.

The trolley 45 rides on the transport conveyor track 20 and rotatably suspends the article carrier 17 from the transport conveyor track 20.

The striker tab 49 extends vertically from one side of the article carrier 17 to enable a determination to be made as to whether or not the carrier 17 has a predetermined rotational orientation in relation to the process conveyor 14.

The respective functions of the other elements of the article carrier 17 are described later herein with reference to other components of the irradiation system with which these elements functionally cooperate.

Referring to Figure 1. 2. 4. 5A. 5B. 6A and 6B. the process conveyor 14 supports the article carriers 17 and transports the article carriers 17 past the radiation source at a first speed: and the transport conveyor 12 transports the article carriers 17 from the loading area 34 at a second speed that differs from the first speed. In order to most efficiently utilize the energy of the radiation beam emitted by the radiation source 10, the spacing between the article carriers 17 as they are transported by the process conveyor 14 past the radiation source 10 must be as small as practically possible. To achieve consistent close spacing between the article carriers 17 as the article carriers are being transported by the process conveyor 14, the load conveyor 13 is adapted for engaging the article carriers 17 and for transporting the engaged article carriers 17 from the transport conveyor 12 to the process conveyor 14 at a speed that is varied during said transport by the load conveyor 13 in such a manner that the article carriers 17 are so positioned on the process conveyor 14 that there is a predetermined separation distance, such as 2,54 cm (one inch) between adjacent positioned article carriers 17. With 2,54 cm (one-inch) spacing between article carriers 17 having a length of 101 cm (forty inches) and with end members 39 of 1,27 cm (one-half-inch) thickness, the space between the interiors of adjacent positioned article carriers is approximately 5cm (two inches), whereby the efficiency of radiation beam energy utilization may be as high as 95 percent.

The article carrier struts 40 are disposed differently on one end member 39 than on the other end member 39 so that the struts 40 on one article carrier 17 cannot contact the struts 40 on another article carrier 17 positioned adjacent thereto on the process conveyor 14 with the same lateral orientation as the one article carrier 17 notwithstanding the end-to-end orientation of the article carriers 17; whereby the article carriers 17 can be positioned closer together on the process conveyor 14 than would be possible if the struts 40 on one article carrier 17 could contact the struts 40 on another article carrier 17 when the article carriers 17 are positioned adjacent each other on the process conveyor 14 with the same lateral orientation.

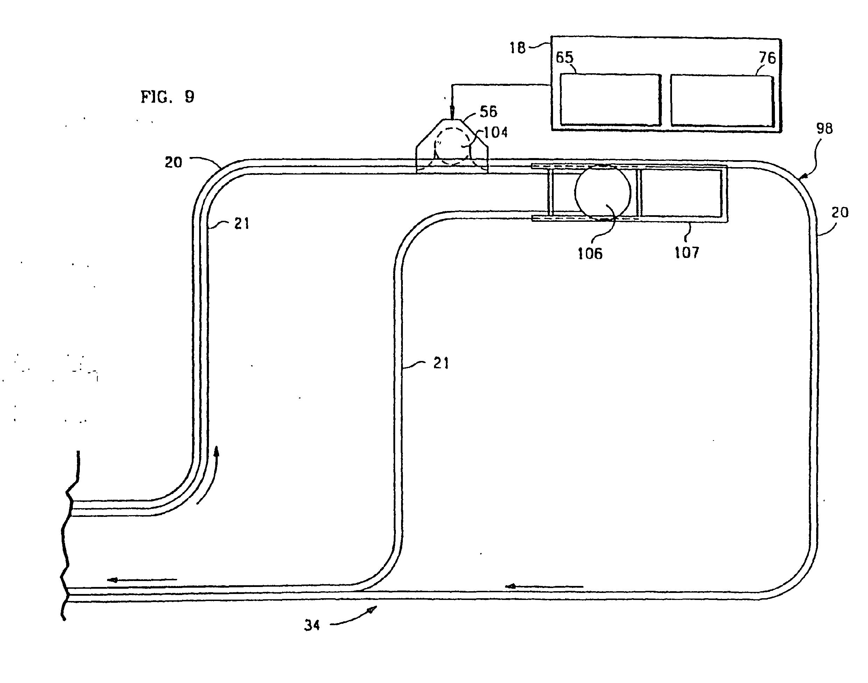

The transport conveyor 12 further includes a movable chain 54 within the slotted tube 21 adjacent the track 20 and dogs 55 attached to the chain 54 at predetermined intervals. The chain 54 is continuously driven through the tube 21. The chain 54 is continuously driven by a drive motor 56 (Figure 9) located outside the housing 19. Operation of the drive motor 56 is controlled by the system controller 18.

The separation distance between adjacent dogs 55 is greater than the maximum article carrier length. As the chain 54 is being driven through the track 20, a dog 55 engages the bar 51 attached to the trolley 45 of an article carrier 17 to thereby pull the article carrier 17 along the path of the transport conveyor track 20.

An escapement 57 is located next to the transport conveyor 12 for restraining the leading edge of an article carrier 17 at a release point 58 at the beginning of the 90-degree turn in the transport conveyor track 20 adjacent a staging area 59 from which the article carriers 17 are transported from the transport conveyor 12 by the load conveyor 13. The speed of movement of the transport conveyor chain 54 must be high enough to ensure an uninterrupted supply of article carriers 17 at the staging area 59, but not so high that the carriers 17 are damaged by contact with one another as they accumulate at the staging area 59. The escapement 57 contacts the bar 51 of the article carrier 17 to restrain further movement of the article carrier 17 with at least a predetermined restraining force until released by the escapement 57. The predetermined restraining force is large enough to cause the transport conveyor dog 55 to disengage from the trolley 45 of the restrained article carrier 17 as the continuously driven transport conveyor chain 54 moves the attached dog 55 past the staging area 59. The number of article carriers 17 being transported by the transport conveyor 12 throughout the irradiation system ideally is such in relation to the relative speeds of the transport conveyor 12 and the process conveyor 14 that the article carriers 17 accumulate behind the article carrier 17 restrained by the escapement 57. The predetermined restraining force provided by the escapement 57 also is large enough to cause the transport conveyor dogs 55 to disengage from the trolleys 45 of the accumulated article carriers 17 as the continuously driven transport conveyor chain 54 moves the attached dogs 55 past the staging area 59. The chain 54 is elevated from the track 20 between the release point 58 and the other side of the process conveyor 14 so as not to be able to again engage a trolley 45 of an article carrier 17 until the article carrier 17 has been transported past the radiation source 10 by the process conveyor 14.

The escapement 57 provides compound control of the movement of the article carriers 17. As one carrier 17 is released, the following carrier 17 is stopped by the escapement 57 until the one carrier 17 has moved beyond the escapement 57. When the escapement 57 is engaged so as to stop the next carrier 17 at the release point 58, the escapement stop for the following carrier 17 releases so the over-riding transport conveyor dog 55 can engage the trolley 45 of the following carrier to transport the following carrier 17 to the release point 58.

The load conveyor 13 includes a pair of chains 60, a latching dog 61 attached to the chains 60, a first sprocket wheel 62 and a second sprocket wheel 63 that are coupled to the chains 60 for driving the chains 60 in a horizontal plane, and a drive motor (not shown) coupled to the second sprocket wheel 63. The speed of the drive motor is controlled by a load conveyor controller 65, which is a part of the system controller 18 (Figure 9) located outside the housing 19. The first sprocket wheel 62 has a large pitch radius which corresponds to the radius of the 90-degree turn corresponding to the 90-degree turn in the transport conveyor track 20 shortly prior to where the article carriers 17 are positioned on the process conveyor 14.

The latching dog 61 is disposed for engaging the leading lug 50 attached to the bottom of the article carrier 17. The latching dog 61 engages the leading lug 50 during both acceleration and deceleration of the article carrier 17 while the article carrier is being moved by the load conveyer 13 from the release point 58 to the process conveyor 14. The latching dog 61 disengages from the leading lug 50 when the latching dog 61 contacts a cam (not shown) before the latching dog 61 begins to move around the second sprocket wheel 63.

The overhead track 20 of the transport conveyor 12 extends over the load conveyor 13 and the process conveyor 14 and guides the transport of the article carriers 17 so that the article carriers 17 are consistently placed on the process conveyor 14 in a predetermined position in relation to the radiation source 10.

The process conveyor 14 includes a first pair of Hyvo chains 66 within a first portion 67 of the process conveyor 14, a second pair of Hyvo chains 68 within a second portion 69 of the process conveyor 14, an auxiliary chain 70, three evenly spaced dogs 71 attached to the auxiliary chain 70, a first set of sprocket wheels 72 for driving the first pair of Hyvo chains 66, a second set of sprocket wheels 73 for driving the second pair of Hyvo chains 68. third set of sprocket wheels 74 for driving the auxiliary chain 70 and a servo drive motor (not shown) coupled to one each of the sprocket wheels 72. 74, which are on a common drive shaft. The speed of the servo drive motor is controlled by a process conveyor controller 76 (Figure 9), which is a part of the system controller 18 located outside the housing 19.

The Hyvo chains 66, 68 of the process conveyor 14 support the article carriers 17 and transport the article carriers 17 past the radiation source 10 as the Hyvo chains 66, 68 are being driven by the servo motor.

There is a gap 77 between the first portion 67 of the process conveyor 14 and the second portion 69 of the process conveyor 14. The gap 77 is located where the radiation beam emitted by the radiation source 10 scans the articles in the article carriers 17 transported past the radiation source 10 by the process conveyor 14 so that the radiation beam does not directly impinge upon the Hyvo chains 66, 68. The first process conveyor portion 67 is coupled to the second process conveyor portion 69 by another chain 79, which is driven by sprocket wheels respectively included in the first set of sprocket wheels 72 and the second set of sprocket wheels 73. The other chain 79 is located beneath the scan of the beam emitted from the radiation source 10. The first pair of Hyvo chains 66. the second pair of Hyvo chains 68, the auxiliary chain 70 and the other chain 79 are all driven at the same speed in response to power provided by the servo motor to one of the sprocket wheels 72 of the first set.

After the load conveyor 13 initially positions the leading edge of an article carrier 17 onto the first portion 67 of the process conveyor 14. one of the three dogs 71 attached to the auxiliary chain 70 engages the trailing side of the leading lug 50 on the bottom of the carrier 17 Just before the latching dog 61 of the transport conveyor moves around the second sprocket wheel 63 and disengages from the leading carrier lug 50.

The first process conveyor portion 67 includes a level section 81. within which the article carriers 17 are supported by the first pair of Hyvo chains 66 while being transported to and past the radiation source 10 by movement of the first pair of Hyvo chains 66. and an upwardly inclined section 82 onto which the article carriers 17 transported by the load conveyor 13 are positioned on the process conveyor 14 so that the article carriers 17 are elevated as they are positioned on the process conveyor 14 so that the article carriers 17 are not supported by the overhead transport conveyor 12 while being transported by the process conveyor 14.

The auxiliary chain dog 71 continues to engage the the leading lug 50 on the bottom of the carrier 17 in order to transport the article carrier at the speed of the process conveyor 14 until the carrier is fully supported by the Hyvo chains 66 of the first process conveyor portion 67. The dog 71 disengages from the leading lug 50 when it is turned away from the leading lug 50 by downward movement of the auxiliary chain 70 adjacent the gap 77.

The gap 77 is of such relatively small breadth that support and transport of the article carrier 17 is transferred from the first process conveyor portion 67 to the second process conveyor portion 69 as the article carrier 17 is being transported past the radiation source 10.

The second process conveyor portion 69 includes a level section 84. within which the article carriers 17 are supported by the second pair of Hyvo chains 68 while being transported past and from the radiation source 10 by movement of the second pair of Hyvo chains 66. As an article carrier 17 leaves the the second process conveyor section 69. the article carrier 17 is again supported by the track 20 of the overhead transport conveyor 12.

Above the discharge end 85 of the second process conveyor section 69. the chain 54 of the transport conveyor 12 descends to the same level as the track 20 of the transport conveyor 12 so that an article carrier 17 leaving the second process conveyor section 69 can be engaged by a transport conveyor dog 55 attached to the chain 54. When the article carrier 17 leaving the second process conveyor section 69 is engaged by a transport conveyor dog 55, the so engaged article carrier 17 is transported from the process conveyor 14 at a speed that is greater than the process conveyor speed.

The speed of process conveyor 14 Is adjustable over a relatively large range in order to subject the articles carried by the article carriers 17 to a prescribed radiation dosage within a range of radiation dosages. In all cases, the speed of the transport conveyor chain 54 exceeds the speed of the process conveyor 14. In the preferred embodiment the speed of movement of the transport conveyor chain 54 is a constant.

The process conveyor controller 76 controls the servo drive motor for the process conveyor 14 by internal data processing based on quadrature format encoder counts. The controller 76 uses a proportional integrated differential (PID) loop in order to reduce the difference between a predetermined speed that is proportional to selected process conveyer drive speed and the actual servo motor armature speed (as indicated by the encoder counts) to be as close to zero as possible. By selecting an encoder with sufficient resolution and programmable error tolerances, drive speed errors are held within prescribed limits.

The system controller 18 monitors the accuracy of the speed control achieved by the PID loop by passing the process conveyor drive encoder speed output of the process conveyor controller 76 to a programmable logic controller (PLC), which at each control cycle update period compares this value to a set point speed commanded by the PLC program. This method verifies that the PLC Instructed speed value is being achieved. Should the monitored speed fall outside a predetermined range, the system controller 18 turns off all of the conveyors 12, 13, 14, 15 and the radiation source 10 to interrupt transport of the article carrier 17 past the radiation source 10 by the process conveyor 14 and to interrupt the emission of radiation by the radiation source 10.

The system controller 18 also continuously measures the actual speed at which the article carrier 17 is being transported past the radiation source 10. Such article transport speed may differ from the process conveyor speed if there is slippage between the article carrier 17 and the process conveyor 14 and/or if movement of the carrier 17 Is impeded by extraneous means. Limit switches 86 and 86a are disposed respectively adjacent one the Hyvo chains 66, 68 in each portion 67, 69 of the process conveyor 14 so as to contact the serrated edge 53 on the member 52 extending from the article carrier on the side of the process conveyor 14 on which the limit switches 86, 86a are located and to be periodically operated by such contact with the serrated edge 53 as the article carries 17 is being transported by the process conveyor 14 past the radiation source 10. The system controller 18 measures the frequency of said operation of the limit switches 86, 86a and turns off all of the conveyors 12, 13, 14, 15 and the radiation source 10 when the measured frequency is outside a predetermined frequency range such that the speed at which the article carrier 17 is being transported is outside of a given speed range.

Once the condition that caused either the monitored speed of the process conveyor drive motor or the measured frequency of operation of either of the limit switch 86, 86a to be outside their respective predetermined ranges has been identified and alleviated, operation of all of the conveyors 12. 13. 14. 15 and operation of the radiation source 10 are resumed. Upon such resumption, the process conveyor controller 76 controls the acceleration and speed of transport by the process conveyor servo drive motor in relation to a given scanning energy level rise rate and a given width of the radiation beam in the directon of transport such that the portion of the article being scanned upon said interruption of radiation and transport is scanned with a total pre-and-post-interruption radiation dosage within a prescribed dosage range.

Once an article carrier 17 is positioned on the process conveyor 14 and being transported past the radiation source 10, contact by a following carrier 17 is not allowed because such contact would affect the uniform motion of the carrier 17 past the radiation source 10. The load conveyor controller 65 controls the acceleration and speed of the load conveyor 13 to prevent contact between the article carriers 17 as they are positioned on the process conveyor 14 such that there is a predetermined distance between adjacent positioned article carriers 17.

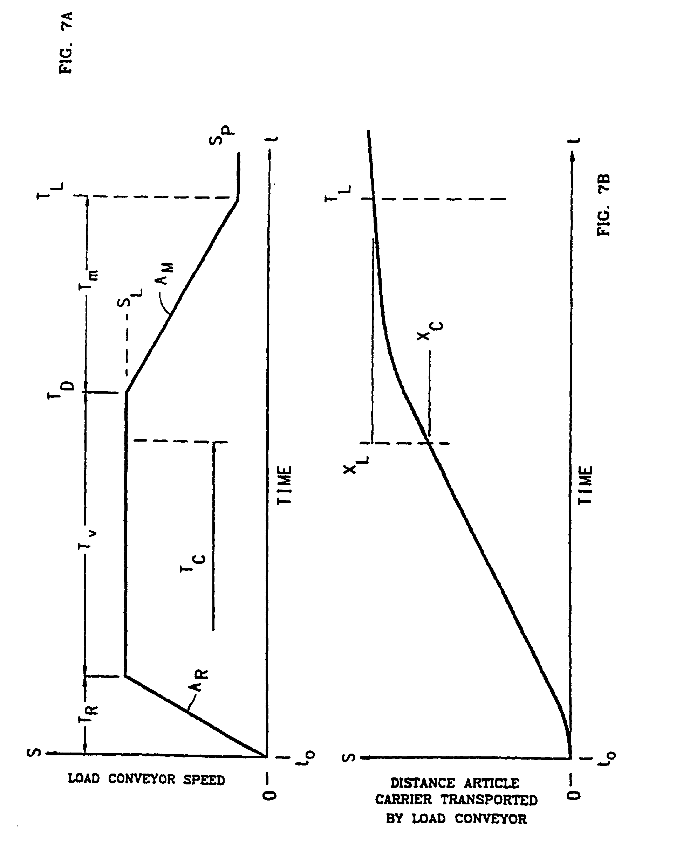

A characteristic curve of the speed of the load conveyor 13 as a function of time is shown in Figure 7A.

A characteristic curve of the distance over which each article carrier 17 is transported by the load conveyor 13 as a function of time is shown in Figure 7B. which has the same time scale as Figure 7A.

Referring to Figure 7A, the load conveyor 13 begins movement from the release point 58 at a time $t_0$, by being accelerated at an acceleration rate $A_R$ for a period of time $T_R$ to a speed $S_L$ that is greater than the speed Sp of the process conveyor 14. The load conveyor 13 then transports the article carrier 17 at the speed $S_L$ for a variable period of time $T_V$ until a time $t_D$, when the load conveyor 13 begins to decelerate at a rate of deceleration $A_M$ for a variable period of time $T_M$ which ends at a total elapsed time $T_L$ from the time to when the speed of the load conveyor 13 matches the speed Sp of the process conveyor 14 whereupon the leading edge of the article carrier 17 is placed on the upwardly inclined section 82 of the process conveyor 14.

Referring to Figure 7B, the distance $X_L$ over which each article carrier 17 is transported by the load conveyor 13 during the time period $T_L$ is a constant in accordance with the dimensions of the load conveyor 13.

Referring again to Figure 7A, although the speed Sp of the process conveyor 14 may be adjusted from time to time in accordance with the radiation dosage requirements for the particular articles being transported past the radiation source, in the preferred embodiment, the total elapsed time $T_L$ over which the load conveyor 13 transports an article carrier 17 from the release point 58 to the process conveyor 14 is constant, notwithstanding the speed $S_P$ of the process conveyor 14. Also, in the preferred embodiment, the acceleration rate $A_R$, the acceleration time period $T_R$, the load conveyor speed $S_L$ during the period $T_V$ between acceleration and deceleration, and the deceleration rate $A_M$ all are constants for all process conveyor speeds $S_P$.

Therefore, in the preferred embodiment, the time $t_D$. at which the load conveyor 13 begins to decelerate is earlier when the speed Sp of the process conveyor 14 is slower.

The total elapsed time $T_L$ from the time $t_0$ until the speed of the load conveyor 13 matches the speed $S_P$ of the process conveyor 14 is equal to the sum of the acceleration time period $T_R$, the variable time period $T_V$ and the variable deceleration time period $T_M$.

$$T_L = T_R + T_V + T_M; \quad (Eq.1)$$

wherein

$$T_V = \frac{X_L - S_L{}^2/2A_R - (S_L{}^2 - S_P{}^2)/2A_M}{S_L}; \quad (Eq.2)$$

and

$$T_M = \frac{S_L - S_P}{A_M}. \quad (Eq.3)$$

The time internal $T_I$ between the beginning of transport of successive article carriers 17 by the transport conveyor 13 is determined in accordance with the length $L_C$ of the article carrier 17, the predetermined separation distance $L_S$ between successive article carriers 17 while being transported by the process conveyor 14 past the radiation source 10, and the speed Sp of the process conveyor 14.

$$T_I = \frac{L_C + L_S}{S_P} \quad (Eq.4)$$

To prevent interference between the carrier 17 that is released onto the load conveyor 13 and the following carrier 17, there must be a time delay $T_D$ before the following carrier 17 can be released.

The time interval $T_I$ must be greater than the sum of the carrier release time delay $T_D$ plus the time period $T_P$ for the next carrier 17 to advance to the release point 58 plus the time period $T_G$ for the transport conveyor dog 55 to travel a distance equal to the spacing distance $X_G$ between the dogs 55 on the chain 54.

$$T_I > T_D + T_P + T_G \quad (Eq.5)$$

The time period $T_P$ is dependent upon the length $L_C$ of the article carrier 17 and the speed $S_T$ of movement of the transport conveyor dogs 55.

$$T_P = \frac{L_C}{S_T} \quad (Eq.6)$$

The time period $T_G$ is dependent upon the spacing distance $X_G$ between the transport conveyor dogs 55 and the speed $S_T$ of movement of the transport dogs 55.

$$T_G = \frac{X_G}{S_T} \quad (Eq.7)$$

In order to obtain the predetermined separation distance $L_S$ between successive article carriers 17 on the process conveyor 14, the time interval $T_I$ must also be greater than the total time $T_L$ over which the load conveyor 13 transports the article carrier 17 plus the time $T_G$ required for a transport conveyor dog 55 to travel the dog spacing distance $X_G$.

$$T_I > T_L + T_G \quad (Eq.8)$$

The time $t_D$ at which deceleration by the load conveyor 13 begins is the sum of the acceleration time period $T_R$ plus the variable time period $T_V$ of constant load conveyor speed $S_L$.

$$t_D = T_R + T_V \quad (Eq.9)$$

The minimum time $t_{D_{MIN}}$ at which deceleration by the load conveyor 13 can begin must be greater than the time interval $T_C$ beginning at the release time $t_0$ required for an article carrier 17 to travel such a distance $X_C$ as to be sufficiently clear of the next released carrier 17 as to prevent contact between the successively transported carriers 17. The distance $X_C$ is determined by the geometrical dimensions of the articles carriers 17 and the path traveled by the article carriers 17 from the release point 58 around the 90-degree turn and then straight to the process conveyor 14.

$$t_{D_{MIN}} = T_R + T_{V_{MIN}} > T_C; \quad (Eq.10)$$

wherein $t_{DMIN}$ is dependent upon the minimum process conveyor speed $S_{PMIN}$.

$$T_{V_{MIN}} = \frac{X_L - S_L{}^2/2A_R - (S_L{}^2 - S_{P_{MIN}}{}^2)/2A_M}{S_L}; \quad (Eq.11)$$

and

$$T_C = \frac{X_C}{S_L} + \frac{S_L}{2A_R}. \quad (Eq.12)$$

In the preferred embodiment, the clearance distance $X_C$ is considerably larger than the length $L_C$ of the article carrier 17 because of the movement of the article carriers 17 around a 90-degree turn, as described above.

In alternative preferred embodiments, one or more of the total time $T_L$ over which the load conveyor 13 transports an article carrier 17 from the release point 58 to the process conveyor 14, the acceleration rate $A_R$, the acceleration time period $T_R$. the load conveyor speed $S_L$ during the period $T_V$ between acceleration and deceleration, and the deceleration rate $A_M$ may be adjusted for different process conveyor speeds $S_P$.

The load conveyor controller 65 is programmed to establish the acceleration $A_R$ and the deceleration $A_M$ as functions of time. By maintaining the acceleration rate $A_R$. the acceleration time period $T_R$, the load conveyor speed $S_L$ during the period $T_V$ between acceleration and deceleration, and the deceleration rate $A_M$ as constants for all process conveyor speeds $S_P$, programming of the load conveyor controller 65 is simplified.

The load conveyor controller 65 and the process conveyor controller 76 each have a finite encoder count capacity which requires that the count be initialized periodically to avoid overflowing the count register. For the load conveyor controller 65 and the the process conveyor controller 76, initialization occurs when an auxiliary chain dog 71 contacts and thereby operates a limit switch 87 during each carrier movement cycle. This method of periodic encoder count initialization maintains system accuracy by eliminating accumulated count errors which would produce positional drift and adversely affect system reliability.

During operation, the point in time when the load conveyor 13 begins to transport an article carrier from the release point 58 is determined by subtracting a calculated time value $T_Q$ from the overall time interval $T_I$. The time value $T_Q$ is determined by the geometrical dimensions of the load conveyor 13 and the process conveyor 14 and the location of the limit switch 87 that is operated by the auxiliary chain dog 71.

With the radiation source 10 being disposed along an approximately horizontal axis, the disposition of the process conveyor 14 in relation to the radiation source 10 is such that articles carried by article carriers 17 having a first horizontal orientation receive radiation impinging upon a first side of the articles.

The reroute conveyor 15 branches from the transport conveyor 12 at a track switch 88 located beyond the process conveyor 14 and transports those article carriers 17 carrying articles that have received radiation impinging upon only the first side of the articles.

Operation of the track switch 88 occurs in response to operation of one or the other of a pair of limit switches 89, 90, which are mounted in stationary positions on opposite sides of the transport conveyor track 20 between the process conveyor 14 and the track switch 88 for detecting whether or not an article carrier 17 transported from the process conveyor 14 has been reoriented. One or the other of the limit switches 88, 89 is operated by contact with the striker tab 49 extending vertically from one side of the outer collar 47 of the carrier 17 after the carrier 17 has been transported past the radiation source 10 by the process conveyor 14.

When the article carrier 17 that has just been transported past the radiation source 10 is oriented such that the radiation impinged on the first side of the articles in the article carrier 17, the striker tab 49 is on the same side of the transport conveyor 12 as the limit switch 90, whereupon the striker tab 49 contacts the limit switch 90 as the carrier is being transported past the limit switch 90 to operate the limit switch 90 to cause the track switch 88 to be so operated as to route the article carrier 17 onto the reroute conveyor 15.

The reroute conveyor 15 also is an overhead power and free conveyor, which includes a track extending from the track switch 88 to a passive merge junction 91, from which track the article carriers 17 are suspended during transport, and a chain with dogs attached thereto disposed to one side of the reroute conveyor track so that such dogs can engage the bar 51 attached to the trolley 45 of an article carrier 17 to thereby push the article carrier 17 along the path of the reroute conveyor track. The reroute conveyor chain (not shown) is coupled by gears (not shown) to the transport conveyor chain 54 and is thereby driven at the same speed at :he transport conveyor chain 54.

Article carriers 17 transported by the reroute conveyor 15 are reoriented about a vertical axis by 180 degrees and transferred back onto the transport conveyor 12 at the passive merge junction 91 prior to the staging area 59 for retransportation by the transport conveyor 12 and the load conveyor 13 to the process conveyor 14 and for retransportation past the radiation source 10 by the process conveyor 14 so that a second side of the carried articles opposite to the first side receives impinging radiation from the radiation source 10.

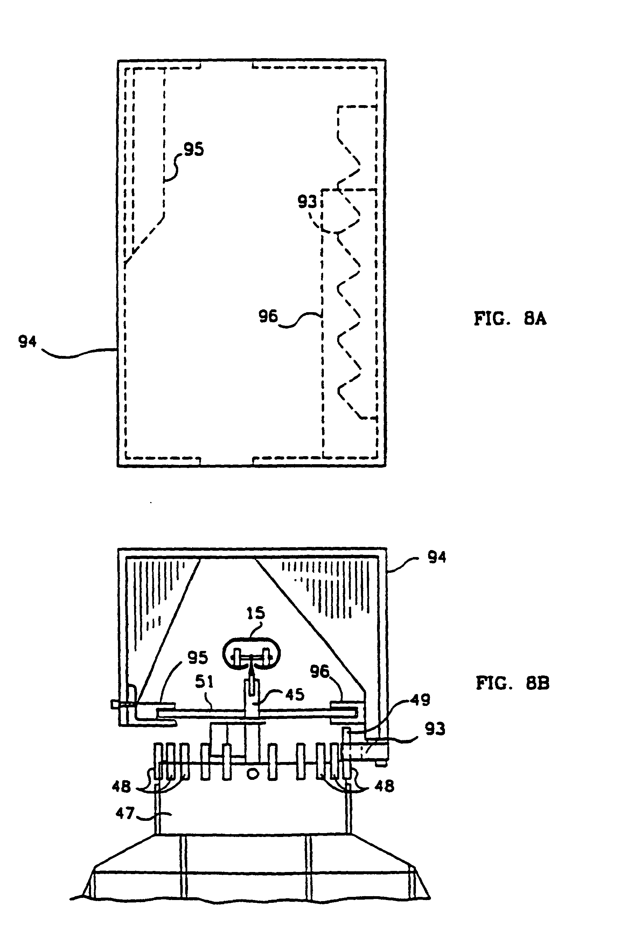

The article carrier 17 is constructed to rotate so that it can be reoriented about a vertical axis by sequential engagement with a gear rack 93 disposed adjacent the reroute conveyor 15. Referring to Figures 8A and 8B. the gear rack 93 is supported by a framework 94.

As indicated above, the trolley 45 rides on the transport conveyor track 20 and is coupled to the article carrier top cross member 38 in such a manner as to rotatably suspend the article carrier 17 from the conveyor track 20. The inner collar 46 is non-rotatably attached to the trolley 45: and the outer collar 47 is non-rotatably attached to the top cross member 38 at the top of the article carrier 17. The outer collar 47 is rotatable in relation to the inner collar 46 and thereby is rotatable in relation to the trolley 45 so that the article carrier 17 is rotatable in relation to the reroute conveyor 15.

The series of pins 48 attached to the outer collar 47 are vertically oriented when the article carrier 17 is suspended from the reroute conveyor 15 and are thereby disposed to sequentially engage the teeth of the gear rack 93, which is mounted in a stationary position in relation to the track of the reroute conveyor track 15, such that as the article carrier 17 Is being transported by the reroute conveyor 15, the pins 48 are sequentially engaged by the gear rack 93 to rotate the article carrier 17. The interaction between the pins 48 and the gear rack 93 rotates the article carrier by 180 degrees.

A guide mechanism including bearings and detents couple the inner collar 46 to the outer collar 47 In order to maintain the rotational orientation of the article carrier 17 when the carrier 17 is not being rotated by the engagement of the pins 48 with the gear rack 93.

Also supported within the framework 94 are a first slotted member 95 laterally disposed on the opposite side of the framework 94 from the gear rack 93 adjacent the entrance end of the framework 94 and a second slotted member 96 laterally disposed on the same side of the framework 94 as the gear rack 93, adjacent the exit end of the framework 94, but below the the gear rack 93. These two slotted members 95, 96 are disposed at the height of the bar 51 of an article carrier 17 supported from the reroute conveyor track 15 within the framework 94 so as to provide restraint against lateral movement of the article carrier 17 as the article carrier 17 is being rotated by the interaction between the pins 48 and the gear rack 93 as the article carrier is being transported along the reroute conveyor track 15.

A limit switch 92 is mounted in a stationary position between the gear rack 93 and the track switch 88 for detecting the presence of an article carrier 17 on the reroute track 15. The limit switch 92 is disposed in relation to the reroute conveyor track 15 so that it is operated by contact with the striker tab 49 extending vertically from one side the outer collar 47 of the article carrier 17.

Another limit switch 97 is mounted in a stationary position in relation to the reroute conveyor 15 between the gear rack 93 and the merge junction 91 for detecting whether or not an article carrier 17 transported onto the reroute conveyor 15 from the process conveyor 14 has been reoriented 180 degrees by the gear rack 93. If the carrier 17 has been rotated 90 degrees about a vertical axis by the gear rack 93, the limit switch 97 is operated by contact with the striker tab 49 extending vertically from one side the outer collar 47 of the carrier 17.

The limit switches 92 and 97 are connected to the system controller 18; and when the correct orientation of an article carrier 17 is not detected by operation of the limit switch 97 within a predetermined time window following operation of the limit switch 92, the system controller 18 responds by interrupting both radiation from the radiation source 10 and transport of all of the article carriers 17 by all of the conveyors 12, 13, 14. 15 of the conveyor system. After the article carrier 17 has been correctly oriented, operation of all of the conveyors 12, 13, 14, 15 and operation of the radiation source 10 are resumed, as described above.

When the article carrier 17 that has just been transported past the radiation source 10 is oriented such that the radiation impinged on the second side of the articles in the article carrier 17, the striker tab 49 is on the same side of the transport conveyor 12 as the limit switch 89, whereupon the striker tab 49 contacts the limit switch 89 as the carrier is being transported past the limit switch 89 to operate the limit switch 89 to cause the track switch 88 to be so operated as to route the article carrier 17 onto an extended portion 99 of the transport conveyor 12 for transportation to an unloading area 98.

Another limit switch 100 is mounted in a stationary position on the same side of the transport conveyor track 20 as the limit switch 89 and adjacent the extended portion 99 of the transport conveyor 12 for detecting when the article carrier 17 that has just been transported past the radiation source 10 is oriented such that the radiation impinged on the second side of the articles in the article carrier 17, which indicates proper operation of the track switch 88. The limit switch 100 is operated by contact with the striker tab 49 that extends vertically from the one side of the outer collar 47 of the carrier 17 when the carrier 17 that has just been transported past the radiation source 10 by the process conveyor 14 is correctly routed by the track switch 88.

If the limit switch 100 is not operated within a predetermined time window following operation of the limit switch 89, a malfunction of the track switch 88 is detected.

The limit switch 100 is connected to the system controller 18: and if the limit switch 100 is not operated within a predetermined time window following operation of the limit switch 89, a malfunction of the track switch 88 is detected by the system controller 18. When a malfunction of the track switch 88 is so detected, the system controller 18 responds by interrupting both radiation from the radiation source 10 and transport of all of the article carriers 17 by all of the conveyors 12, 13, 14, 15 of the conveyor system. After the article carrier 17 has been correctly oriented, operation of all of the conveyors 12. 13. 14. 15 and operation of the radiation source 10 are resumed

In the loading area 34, a mask 102 is mounted in a stationary position in relation to the transport conveyor 12 for blocking passage of an article carrier 17 that does not have the striker tab 49 on the side of the article carrier 17 that will receive impinging radiation from the radiation source 10 when the article carrier 17 is first transported past the radiation source 10. The mask 102 has an opening that permits passage of the article carrier 17 only when the striker tab 49 is on such side of the article carrier 17.

Within the entry 31 to the process chamber 30 and the passageway 32, the portion of the transport conveyor 12 that transports the article carriers 17 from the loading area 34 to the process chamber 30 is elevated with respect to the extended portion 99 of the transport conveyor 12 that transports the article carriers from the process conveyor 14 to the unloading area 98.

Referring to Figure 9, the transport conveyor chain within the slotted tube 21 is driven by a sprocket wheel 104 coupled to the drive motor 56 and passes around an idler sprocket wheel 106 coupled to a chain tensioning device 107. The track tube 20 takes a separate route from the slotted tube 21 within the unloading area 98 and the loading area 34 so that the article carriers can be manually stopped and unloaded. The article carriers 17 are then pushed manually along the route of the track 20 to the loading area 34 where they are loaded with a new set of articles to be irradiated. Beyond the loading area 34 the tracks 20 and 21 merge to be adjacent each other so as to enable the transport conveyor 12 to transport the article carriers 17 into the process chamber 30.

**Claims**

1. A system for irradiating articles on article carriers (17), including:

   a radiation source (10) for providing a radiation beam:
   a conveyor (14) for transporting the article carrier past the radiation beam to obtain an irradiation of the articles on the article carriers, and
   a controller (76) for monitoring the movement of the article carriers past the radiation beam within particular limits of a particular speed **characterized by**:
   a system controller (18) having means to interrupt the operation of the radiation source (10) and the movement of the conveyor (14) in the event that the controller (18) determines that the conveyor (14) is transporting the article carriers (17) past the radiation source (10) not within particular limits of a particular speed.

2. A system as set forth in claim 1, including:

   switch means for producing a signal (86, 86a) upon each movement of a successive one of the article carriers (17) past the radiation beam, and
   control means which may be the system controller (18), for determining the frequency of the signals produced by the last mentioned switch means to indicate whether the successive ones of the article carriers are being moved by the conveyor past the radiation beam within the particular limits of the particular speed.

3. A system as set forth in either of claim 1 and claim 2, including:

   the conveyor (14) constituting a process conveyor,
   a re-route conveyor (15) coupled to the process conveyor for transporting the article carriers which carry articles that have received radiation on a first side of the articles,
   passive means (93) disposed adjacent the re-route conveyor for reorienting the article carriers through an angle of substantially 180˚ as the article carriers are being transported by the re-route conveyor, and
   means (91) for transferring the re-oriented article carriers from the re-route conveyor to the process conveyor for movement of the article carriers by the process conveyor past the radiation beam to obtain an irradiation of the second side of the articles.

4. A system as set forth in claim 3, including
   switch means (92, 97) for determining whether the article carriers have been reoriented properly on the re-route conveyor, and
   control means (18) for interrupting the radiation beam and the movement of the article carriers past the radiation beam when the last mentioned means (57, 49) determines that the article carriers have not been re-oriented properly on the re-route conveyor.

5. A system as set forth in any of claims 1 to 4, including:

   storage means (59) for storing the article carriers in sequence in a staging area,
   escapement means (57) for releasing each of the article carriers in sequence from the staging area for movement of the article carriers by the conveyor past the radiation beam, and
   means for releasing each of the articles from the escapement to the conveyor means in sequence when the previous one of the articles in the sequence has moved past the escapement means.

6. A system as set forth in any of claims 1 to 5, including:

   a loading area (34) for holding the article carriers for transfer to the process conveyor,
   an unloading area (98) for holding the article carriers after the irradiation of the articles on the article carriers by the radiation beam,

switching means (89, 100) for determining whether the article carriers have been properly routed to the unloading area after the irradiation of the articles on the articles carriers by the radiation beam, and

control means (18) for interrupting the radiation of the articles on the article carriers by the radiation beam and the movement of the articles by the process conveyor when the last mentioned means determines that the article carriers have not been properly routed to the unloading area.

7. A method of irradiating articles on article carriers including the steps of:

providing a radiation beam,
transporting the article carriers past the radiation beam to obtain an irradiation of the articles on the articles carrier by the radiation beam,
**characterised by** the following steps:
determining the speed at which the articles are being transported past the radiation beam,
monitoring the movement of the article carriers past the radiation beam, in accordance with the speed determination, to maintain the movement of the article carriers past the radiation beam within particular limits of a particular speed,
determining whether the speed of movement of the article carriers past the radiation beam is within the particular limits of the particular speed, and
interrupting the radiation from the radiation beam, and the movement of the article carriers past the radiation beam, when the speed of movement of the article carriers past the radiation beam is determined to be not within the particular limits of the particular speed.

8. A method as set forth in claim 7, including the steps of:

producing (18, 86, 86a, 53) a signal upon each movement of a successive one of the article carriers past the radiation source, and
determining (18) the frequency of the signals to indicate whether the successive ones of the article carriers are being moved past the radiation beam within the particular limits of the particular speed.

9. A method as set forth in either of claims 7 and 8, including the steps of:

interrupting (18) the radiation beam and the movement of the article carriers past the radiation beam when the determined frequency is outside of the particular limits of the particular frequency range.

10. A method as set forth in any of claims 7 to 9, including the steps of:

re-routing (15) the article carriers for a movement of the article carriers a second time past the radiation source when the articles on the article carriers have received radiation on a first side of the articles,
passively re-orienting (49, 90) the article carriers through an angle of substantially 180˚ as the article carriers are being re-routed, and
moving the article carriers for a second time past the radiation beam after the article carriers have been re-oriented through the angle of substantially 180˚.

11. A method as set forth in claim 10, including the steps of:

determining (97, 92) whether the article carriers have been re-oriented properly through the angle of substantially 180˚, and
interrupting (18) the radiation beam and the movement of the article carriers past the radiation beam when it is determined that the article carriers have not been re-oriented properly.

12. A method as set forth in any of claims 7 to 11, including the steps of:

storing (59) the article carriers in sequence in a staging area,
transferring (75, 87) each of the article carriers in sequence from the staging area for movement of the article carrier past the radiation beam, and
preventing (65, 76) each of the article carriers from being released from the staging area until after the previous one of the articles in the sequence has been released and transferred from the staging area.

**13.** A method as set forth in any of claims 7 to 12, including the steps of:

providing a loading area (34) for holding the article carriers for movement past the radiation beam,
providing an unloading area (98) for holding the article carriers after the irradiation of the article carriers by the radiation beam,
routing the article carriers to the unloading area after the irradiation of the articles on the article carriers by the radiation beam,
determining (88, 89, 100) whether the article carriers have been properly routed to the unloading area after the articles on the article carriers have been irradiated by the radiation beam, and
interrupting (18) the radiation beam and the movement of the article carriers past the radiation beam when it is determined that the article carriers have not been properly routed to the unloading area after the articles on the article carriers have been irradiated by the radiation beam.

**14.** A method as set forth in any of claims 10 to 13, including the steps of:

detecting (89, 90) whether or not the article carriers have been re-routed after the articles on the article carriers have been irradiated on one side of the articles, and
re-routing (88) the article carriers when this detection indicates that the article carriers have not been re-routed and routing the article carriers to the unloading area when the detection indicates that the article carriers have been re-routed.

**15.** A method as set forth in any of claims 7 to 14, including the steps of:

accelerating the article carriers to a speed above the particular speed before the movement of the article carriers past the radiation beam, and
thereafter decelerating the article carriers to the particular speed for the movement of the article carriers past the radiation beam at the particular speed.

**Patentansprüche**

**1.** System zur Bestrahlung von Artikeln auf Artikelträgern (17), mit:

- einer Bestrahlungsquelle (10) zur Bereitstellung eines Bestrahlungsstrahls,
- einer Fördereinrichtung (14) zum Transport des Artikelträgers an dem Bestrahlungsstrahl vorbei, um eine Bestrahlung der Artikel auf den Artikelträgern zu erreichen, und
- einer Steuervorrichtung (76) zur Überwachung der Bewegung der Artikelträger an dem Bestrahlungsstrahl vorbei innerhalb bestimmter Grenzen einer bestimmten Geschwindigkeit,

**gekennzeichnet durch**:

- eine Systemsteuervorrichtung (18) mit Einrichtungen zur Unterbrechung des Betriebs der Bestrahlungsquelle (10) und der Bewegung der Fördereinrichtung (14) für den Fall, dass die Steuervorrichtung (18) bestimmt, dass die Fördereinrichtung (14) die Artikelträger (17) nicht innerhalb bestimmter Grenzen einer bestimmten Geschwindigkeit an der Bestrahlungsquelle (10) vorbei transportiert.

**2.** System nach Anspruch 1, mit:

- einer Schalteinrichtung zur Erzeugung eines Signals (86, 86a) bei jeder Bewegung eines darauffolgenden Artikelträgers (17) an der Bestrahlungsquelle vorbei, und
- einer Steuereinrichtung, die die Systemsteuervorrichtung (18) sein kann, zur Bestimmung der Frequenz der Signale, die durch die zuletzt genannte Schalteinrichtung erzeugt wurden, um anzuzeigen, ob die darauffolgenden Artikelträger durch die Fördereinrichtung an dem Bestrahlungsstrahl innerhalb der bestimmten Grenzen der bestimmten Geschwindigkeit vorbei bewegt wurden.

**3.** System nach Anspruch 1 oder 2, mit:

- der eine Prozessfördereinrichtung bildenden Fördereinrichtung (14),

- einer Umleitfördereinrichtung (15), die mit der Prozessfördereinrichtung gekoppelt ist, um die Artikelträger zu transportieren, die Artikel tragen, die eine Bestrahlung auf einer ersten Seite der Artikel empfangen haben,
- einer Passiveinrichtung (93), die angrenzend an die Umleitfördereinrichtung zur Neuausrichtung der Artikelträger um einen Winkel von im Wesentlichen 180˚ angeordnet ist, wenn die Artikelträger von der Umleitfördereinrichtung transportiert werden, und
- einer Einrichtung (91) zur Überführung der neuausgerichteten Artikelträger von der Umleitfördereinrichtung zu der Prozessfördereinrichtung für eine Bewegung der Artikelträger durch die Prozessfördereinrichtung an dem Bestrahlungsstrahl vorbei, um eine Bestrahlung der zweiten Seite der Artikel zu erreichen.

4. System nach Anspruch 3, m it:

- einer Schalteinrichtung (92, 97) zur Bestimmung, ob die Artikelträger auf der Umleitfördereinrichtung richtig neu ausgerichtet worden sind, und
- einer Steuereinrichtung (18) zur Unterbrechung des Bestrahlungsstrahls und der Bewegung der Artikelträger an dem Bestrahlungsstrahl vorbei, wenn die zuletzt genannte Einrichtung (57, 49) bestimmt, dass die Artikelträger nicht richtig auf der Umleitfördereinrichtung neu ausgerichtet wurden.

5. System nach einem der Ansprüche 1 bis 4, mit:

- einer Speichereinrichtung (59) zur aufeinanderfolgenden Speicherung der Artikelträger in einem Zwischenspeicherbereich,
- einer Hemmeinrichtung (57) zur aufeinanderfolgenden Freigabe jedes der Artikelträger aus dem Zwischenspeicherbereich für eine Bewegung der Artikelträger durch die Fördereinrichtung an dem Bestrahlungsstrahl vorbei, und
- einer Einrichtung zur aufeinanderfolgenden Freigabe jedes der Artikel von der Hemmeinrichtung zu der Fördereinrichtung, wenn der in der Folge vorhergehende Artikel sich an der Hemmeinrichtung vorbei bewegt hat.

6. System nach einem der Ansprüche 1 bis 5, mit:

- einem Beladungsbereich (34) zum Halten der Artikelträger für eine Überführung zu der Prozessfördereinrichtung,
- einem Entladungsbereich (98) zum Halten der Artikelträger nach der Bestrahlung der Artikel auf den Artikelträgern durch den Bestrahlungsstrahl,
- einer Schalteinrichtung (98, 100) zur Bestimmung, ob die Artikelträger nach der Bestrahlung der Artikel auf den Artikelträgern durch den Bestrahlungsstrahl richtig zu dem Entladungsbereich geleitet wurden, und
- einer Steuereinrichtung (18) zur Unterbrechung der Bestrahlung der Artikel auf den Artikelträgern durch den Bestrahlungsstrahl und der Bewegung der Artikel durch die Prozessfördereinrichtung, wenn die zuletzt genannte Einrichtung bestimmt, dass die Artikelträger nicht richtig zu dem Entladungsbereich geleitet wurden.

7. Verfahren zur Bestrahlung von Artikeln auf Artikelträgern, mit den Schritten:

- Bereitstellen eines Bestrahlungsstrahls,
- Transport der Artikelträger an dem Bestrahlungsstrahl vorbei, um eine Bestrahlung der Artikel auf dem Artikelträger durch den Bestrahlungsstrahl zu erhalten,

**gekennzeichnet durch** die folgenden Schritte:

- Bestimmung der Geschwindigkeit, mit der die Artikel an dem Bestrahlungsstrahl vorbei transportiert werden,
- Überwachung der Bewegung der Artikelträger an dem Bestrahlungsstrahl vorbei gemäß der Geschwindigkeitsbestimmung, um die Bewegung der Artikelträger an dem Bestrahlungsstrahl vorbei innerhalb bestimmter Grenzen einer bestimmten Geschwindigkeit zu halten,
- Bestimmung, ob die Geschwindigkeit der Bewegung der Artikelträger an dem Bestrahlungsstrahl vorbei innerhalb der bestimmten Grenzen der bestimmten Geschwindigkeit liegt, und
- Unterbrechung der Bestrahlung von dem Bestrahlungsstrahl und der Bewegung der Artikelträger an dem Bestrahlungsstrahl vorbei, wenn bestimmt wird, dass die Geschwindigkeit der Bewegung der Artikelträger an dem Bestrahlungsstrahl vorbei nicht innerhalb der bestimmten Grenzen der bestimmten Geschwindigkeit liegt.

8. Verfahren nach Anspruch 7, mit den Schritten:

- Erzeugen (18, 86, 86a, 53) eines Signals bei jeder Bewegung eines darauffolgenden Artikelträgers an der Bestrahlungsquelle vorbei, und
- Bestimmung (18) der Frequenz der Signale, um anzuzeigen, ob die darauffolgenden Artikelträger innerhalb der bestimmten Grenzen der bestimmten Geschwindigkeit an dem Bestrahlungsstrahl vorbei bewegt wurden.

9. Verfahren nach einem der Ansprüche 7 und 8, mit den Schritten:

- Unterbrechung (18) des Bestrahlungsstrahls und der Bewegung der Artikelträger an dem Bestrahlungsstrahl vorbei, wenn die bestimmte Frequenz außerhalb der bestimmten Grenzen des bestimmten Frequenzbereichs liegt.

10. Verfahren nach einem der Ansprüche 7 bis 9, mit den Schritten:

- Umleiten (15) der Artikelträger, um die Artikelträger ein zweites Mal an der Bestrahlungsquelle vorbei zu bewegen, wenn die Artikel auf den Artikelträgern eine Bestrahlung auf einer ersten Seite der Artikel empfangen haben,
- Passive Neuausrichtung (49, 90) der Artikelträger um einen Winkel von im Wesentlichen 180˚, wenn die Artikelträger umgeleitet werden, und
- Bewegen der Artikelträger zum zweiten Mal an dem Bestrahlungsstrahl vorbei, nachdem die Artikelträger um den Winkel von im Wesentlichen 180˚ neu ausgerichtet wurden.

11. Verfahren nach Anspruch 10, mit den Schritten:

- Bestimmung (97, 92), ob die Artikelträger um den Winkel von im Wesentlichen 180˚ richtig neu ausgerichtet wurden, und
- Unterbrechung (18) des Bestrahlungsstrahls und der Bewegung der Artikelträger an dem Bestrahlungsstrahl vorbei, wenn bestimmt wurde, dass die Artikelträger nicht richtig neu ausgerichtet wurden.

12. Verfahren nach einem der Ansprüche 7 bis 11, mit den Schritten:

- Aufeinanderfolgendes Speichern (59) der Artikelträger in einem Zwischenspeicherbereich,
- Aufeinanderfolgendes Überführen (75, 87) jedes Artikelträgers aus dem Zwischenlagerbereich zur Bewegung der Artikelträger an dem Bestrahlungsstrahl vorbei, und
- Verhindern (65, 76), dass jeder der Artikelträger von dem Zwischenspeicherbereich freigegeben wird, bis der in der Folge vorausgehende Artikel freigegeben wurde und aus dem Zwischenspeicherbereich überführt wurde.

13. Verfahren nach einem der Ansprüche 7 bis 12, mit den Schritten:

- Bereitstellen eines Beladungsbereichs (34) zum Halten der Artikelträger für eine Bewegung an dem Bestrahlungsstrahl vorbei,
- Bereitstellen eines Entladungsbereichs (98) zum Halten der Artikelträger nach der Bestrahlung der Artikelträger durch den Bestrahlungsstrahl,
- Leiten der Artikelträger zu dem Entladungsbereich nach der Bestrahlung der Artikel auf den Artikelträgern durch den Bestrahlungsstrahl,
- Bestimmen (88, 89, 100), ob die Artikelträger richtig zu dem Entladungsbereich geleitet wurden, nachdem die Artikel auf den Artikelträgern durch den Bestrahlungsstrahl bestrahlt wurden, und
- Unterbrechung (18) des Bestrahlungsstrahls und der Bewegung der Artikelträger an dem Bestrahlungsstrahl vorbei, wenn bestimmt wurde, dass die Artikelträger nicht richtig zu dem Entladungsbereich geleitet wurden, nachdem die Artikel auf den Artikelträgern durch den Bestrahlungsstrahl bestrahlt wurden.

14. Verfahren nach einem der Ansprüche 10 bis 13, mit den Schritten:

- Erfassung (89, 90), ob die Artikelträger umgeleitet wurden oder nicht, nachdem die Artikel auf den Artikelträgern auf einer Seite der Artikel bestrahlt worden sind, und
- Umleiten (88) der Artikelträger, wenn diese Erfassung anzeigt, dass die Artikelträger nicht umgeleitet wurden, und Leiten der Artikelträger zu dem Entladungsbereich, wenn die Erfassung anzeigt, dass die Artikelträger umgeleitet wurden.

**15.** Verfahren nach einem der Ansprüche 7 bis 14, mit den Schritten:

- Beschleunigung der Artikelträger auf eine Geschwindigkeit oberhalb der bestimmten Geschwindigkeit, bevor sich die Artikelträger an dem Bestrahlungsstrahl vorbei bewegen, und
- danach Verzögern der Artikelträger auf die bestimmte Geschwindigkeit, damit sich die Artikelträger mit der bestimmten Geschwindigkeit an dem Bestrahlungsstrahl vorbei bewegen.

**Revendications**

**1.** Système pour irradier des articles sur des supports d'article (17), comprenant :

une source de radiation (10) pour fournir un faisceau de radiation :
un convoyeur (14) pour transporter le support d'article devant le faisceau de radiation afin d'obtenir une irradiation des articles sur les supports d'article, et
un contrôleur (76) pour surveiller le mouvement des supports d'article devant le faisceau de radiation dans des limites particulières d'une vitesse particulière, **caractérisé par** :
un contrôleur de système (18) ayant des moyens pour interrompre le fonctionnement de la source de radiation (10) et le mouvement du convoyeur (14) dans le cas où le contrôleur (18) détermine que le convoyeur (14) transporte les supports d'article (17) devant la source de radiation (10) mais pas dans les limites particulières d'une vitesse particulière.

**2.** Système selon la revendication 1, comprenant :

des moyens de commutation pour produire un signal (86, 86a) suite à chaque mouvement d'un support d'article successif des supports d'article (17) devant le faisceau de radiation, et
des moyens de commande qui peuvent être le contrôleur de système (18), pour déterminer la fréquence des signaux produits par les moyens de commutation dernièrement mentionnés pour indiquer si les supports d'article successifs des supports d'article sont déplacés par le convoyeur devant le faisceau de radiation dans les limites particulières de la vitesse particulière.

**3.** Système selon la revendication 1 et la revendication 2, comprenant :

le convoyeur (14) qui constitue un convoyeur de traitement,
un convoyeur de réacheminement (15) couplé au convoyeur de traitement pour transporter les supports d'article qui supportent des articles qui ont reçu la radiation sur un premier côté des articles,
des moyens passifs (93) disposés de manière adjacente au convoyeur de réacheminement pour réorienter les supports d'article selon un angle de sensiblement 180° au fur et à mesure que les supports d'article sont transportés par le convoyeur de réacheminement, et
des moyens (91) pour transférer les supports d'article réorientés, du convoyeur de réacheminement au convoyeur de traitement pour le déplacement des supports d'article par le convoyeur de traitement devant le faisceau de radiation afin d'obtenir une irradiation sur le deuxième côté des articles.

**4.** Système selon la revendication 3, comprenant :

des moyens de commutation (92, 97) pour déterminer si les supports d'article ont été réorientés correctement sur le convoyeur de réacheminement, et
des moyens de commande (18) pour interrompre le faisceau de radiation et le déplacement des supports d'article devant le faisceau de radiation lorsque les moyens (57, 49) dernièrement mentionnés déterminent que les supports d'article n'ont pas été réorientés correctement sur le convoyeur de réacheminement.

**5.** Système selon l'une quelconque des revendications 1 à 4, comprenant :

des moyens de stockage (59) pour stocker les supports d'article en séquence dans une zone de transfert,
des moyens d'échappement (57) pour libérer chacun des supports d'article en séquence de la zone de transfert pour le déplacement des supports d'article par le convoyeur devant le faisceau de radiation, et
des moyens pour libérer chacun des articles des moyens d'échappement aux moyens de convoyeur en séquence lorsque les précédents articles dans la séquence ont été déplacés au-delà des moyens d'échappement.

**6.** Système selon l'une quelconque des revendications 1 à 5, comprenant :

une zone de chargement (34) pour placer en attente les supports d'article pour le transfert sur le convoyeur de traitement,

une zone de déchargement (98) pour placer en attente les supports d'article après l'irradiation des articles sur les supports d'article par le faisceau de radiation,

des moyens de commutation (89, 100) pour déterminer si les supports d'article ont été correctement acheminés jusqu'à la zone de déchargement après l'irradiation des articles sur les supports d'article par le faisceau de radiation, et

des moyens de commande (18) pour interrompre la radiation des articles sur les supports d'article par le faisceau de radiation et le déplacement des articles par le convoyeur de traitement lorsque les moyens dernièrement mentionnés déterminent que les supports d'article n'ont pas été correctement acheminés vers la zone de déchargement.

**7.** Procédé pour irradier des articles sur des supports d'article comprenant les étapes consistant à :

fournir un faisceau de radiation,

transporter les supports d'article devant le faisceau de radiation afin d'obtenir une irradiation des articles sur les supports d'article par le faisceau de radiation,

**caractérisé par** les étapes suivantes consistant à :

déterminer la vitesse à laquelle les articles ont été transportés devant le faisceau de radiation,

surveiller le déplacement des supports d'article devant le faisceau de radiation, en fonction de la détermination de vitesse, afin de maintenir le déplacement des supports d'article devant le faisceau de radiation dans des limites particulières d'une vitesse particulière,

déterminer si la vitesse de mouvement des supports d'article devant le faisceau de radiation est dans les limites particulières de la vitesse particulière, et

interrompre la radiation du faisceau de radiation, et le déplacement des supports d'article devant le faisceau de radiation, lorsque la vitesse de déplacement des supports d'article devant le faisceau de radiation est déterminée comme n'étant pas dans les limites particulières de la vitesse particulière.

**8.** Procédé selon la revendication 7, comprenant les étapes consistant à :

produire (18, 86, 86a, 53) un signal suite à chaque déplacement d'un support d'article successif des supports d'article devant la source de radiation, et

déterminer (18) la fréquence des signaux pour indiquer si les supports d'article successifs des supports d'article ont été déplacés devant le faisceau de radiation dans les limites particulières de la vitesse particulière.

**9.** Procédé selon l'une ou l'autre des revendications 7 et 8, comprenant l'étape consistant à :

interrompre (18) le faisceau de radiation et le mouvement des supports d'article devant le faisceau de radiation lorsque la fréquence déterminée est hors des limites particulières de la plage de fréquences particulière.

**10.** Procédé selon l'une quelconque des revendications 7 à 9, comprenant les étapes consistant à :

réacheminer (15) les supports d'article pour un déplacement des supports d'article une deuxième fois devant la source de radiation lorsque les articles sur les supports d'article ont reçu la radiation sur un premier côté des articles,

réorienter de manière passive (49, 90) les supports d'article selon un angle de sensiblement 180° au fur et à mesure que les supports d'article sont réacheminés, et

déplacer les supports d'article une deuxième fois devant le faisceau de radiation après que les supports d'article ont été réorientés selon l'angle de sensiblement 180°.

**11.** Procédé selon la revendication 10, comprenant les étapes consistant à :

déterminer (97, 92) si les supports d'article ont été réorientés correctement selon l'angle de sensiblement 180°, et

interrompre (18) le faisceau de radiation et le déplacement des supports d'article devant le faisceau de radiation lorsque l'on détermine que les supports d'article n'ont pas été réorientés correctement.

**17**

**12.** Procédé selon l'une quelconque des revendications 7 à 11, comprenant les étapes consistant à :

stocker (59) les supports d'article en séquence dans une zone de transfert,
transférer (75, 87) chacun des supports d'article en séquence, à partir de la zone de transfert, pour le déplacement du support d'article devant le faisceau de radiation, et
empêcher (65, 76) chacun des supports d'article d'être libéré de la zone de transfert jusqu'au moment situé après que le précédent article des articles dans la séquence a été libéré et transféré de la zone de transfert.

**13.** Procédé selon l'une quelconque des revendications 7 à 12, comprenant les étapes consistant à :

prévoir une zone de chargement (34) pour placer en attente les supports d'article pour le déplacement devant le faisceau de radiation,
prévoir une zone de déchargement (98) pour placer en attente les supports d'article après l'irradiation des supports d'article par le faisceau de radiation,
acheminer les supports d'article jusqu'à la zone de déchargement après l'irradiation des articles sur les supports d'article par le faisceau de radiation,
déterminer (88, 89, 100) si les supports d'article ont été correctement acheminés jusqu'à la zone de déchargement après que les articles sur les supports d'article ont été irradiés par le faisceau de radiation, et
interrompre (18) le faisceau de radiation et le déplacement des supports d'article devant le faisceau de radiation lorsque l'on détermine que les supports d'article n'ont pas été correctement acheminés jusqu'à la zone de déchargement après que les articles sur les supports d'article ont été irradiés par le faisceau de radiation.

**14.** Procédé selon l'une quelconque des revendications 10 à 13, comprenant les étapes consistant à :

détecter (89, 90) si les supports d'article ont été réacheminés ou pas après que les articles sur les supports d'article ont été irradiés sur un côté des articles, et
réacheminer (88) les supports d'article lorsque cette détection indique que les supports d'article n'ont pas été réacheminés et acheminer les supports d'article jusqu'à la zone de déchargement lorsque la détection indique que les supports d'article ont été réacheminés.

**15.** Procédé selon l'une quelconque des revendications 7 à 14, comprenant les étapes consistant à :

accélérer les supports d'article jusqu'à une vitesse supérieure à la vitesse particulière avant le déplacement des supports d'article devant le faisceau de radiation, et
ensuite, ralentir les supports d'article jusqu'à la vitesse particulière pour le déplacement des supports d'article devant le faisceau de radiation à la vitesse particulière.

FIG. 1

FIG. 2

FIG. 3A

FIG. 3B

FIG. 3C

FIG. 4

EP 1 115 121 B1

FIG. 5A

FIG. 5B

23

EP 1 115 121 B1

FIG. 6A

FIG. 6B

EP 1 115 121 B1

FIG. 7A

FIG. 7B

EP 1 115 121 B1

FIG. 8A

FIG. 8B

FIG. 9

18

65    76

56
104

20

21

21

98

20

106    107

34

EP 1 115 121 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 3564241 A
- US 4852138 A
- US 4020354 A